# EUROPEAN PATENT SPECIFICATION

(11) **EP 4 200 461 B1**
(45) Date of publication and mention of the grant of the patent: **07.10.2026**
(21) Application number: 21858889.5
(22) Date of filing: 16.08.2021
(51) Int. Cl.: C23C 14/56, C23C 14/54, C23C 14/16, C23C 14/20, C23C 16/52, H10P 72/00, H10P 72/30, C23C 16/06, C23C 16/54

(54) **PROCESSING SYSTEM FOR PROCESSING A FLEXIBLE SUBSTRATE AND METHOD OF MEASURING AT LEAST ONE OF A PROPERTY OF A FLEXIBLE SUBSTRATE AND A PROPERTY OF ONE OR MORE COATINGS ON THE FLEXIBLE SUBSTRATE**
VERARBEITUNGSSYSTEM ZUR VERARBEITUNG EINES FLEXIBLEN SUBSTRATS UND VERFAHREN ZUR MESSUNG EINER EIGENSCHAFT EINES FLEXIBLEN SUBSTRATS
SYSTÈME DE TRAITEMENT POUR TRAITER UN SUBSTRAT SOUPLE ET PROCÉDÉ DE MESURE D'AU MOINS L'UNE D'UNE PROPRIÉTÉ D'UN SUBSTRAT SOUPLE ET D'UNE PROPRIÉTÉ D'UN OU PLUSIEURS REVÊTEMENTS SUR LE SUBSTRAT SOUPLE

(30) Priority: 21.08.2020 US 202063068826 P
(43) Date of publication of application: 28.06.2023
(73) Proprietor: Elevated Materials Germany GmbH, 63755 Alzenau (DE)
(72) Inventor: DEPPISCH, Thomas, 63743 Aschaffenburg (DE); RANGASAMY, Ezhiylmurugan, San Jose, California 95126 (US); BANGERT, Stefan, 36396 Steinau (DE); ALLISON, Mathew Dean, 60385 Frankfurt am Main (DE)
(74) Representative: Zimmermann & Partner Patentanwälte mbB
(86) International application number: PCT/US2021/046122
(87) International publication number: WO 2022/040075

(56) References cited:
- EP-A1- 2 157 589
- WO-A1-2018/001523
- CN-A- 104 593 743
- CN-A- 107 841 723
- JP-A- H08 225 940
- KR-A- 20090 120 034
- KR-B1- 100 813 572
- US-A- 4 389 970
- US-A- 4 763 601

## Description

### TECHNICAL FIELD

Embodiments of the present disclosure relate to processing system for processing a flexible substrate, particularly roll-to-roll processing system. In particular, embodiments of the present disclosure relate to vacuum processing systems having a measurement system for measuring a property of a flexible substrate and/or a property of one or more coatings provided on the flexible substrate. Further embodiments of the present disclosure relate to methods of measuring a property of a flexible substrate and/or a property of one or more coatings provided on the flexible substrate, particularly in situ.

### BACKGROUND

Processing of flexible substrates, such as plastic films or foils, is in high demand in the packaging industry, semiconductor industries and other industries. Processing may consist of coating a flexible substrate with a material, such as a metal, a semiconductor and a dielectric material, etching and other processing actions conducted on a substrate for the respective applications. Systems performing this task typically include a coating drum, e.g. a cylindrical roller, coupled to a processing system with a roller assembly for transporting the substrate, and on which at least a portion of the substrate is coated.

For example, a coating process such as a CVD process, a PVD process, or an evaporation process, can be utilized for depositing thin layers onto flexible substrates. Roll-to-roll deposition apparatuses are understood in that a flexible substrate of a considerable length, such as one kilometer or more, is uncoiled from a storage spool, coated with a stack of thin layers, and recoiled again on a wind-up spool. In particular, in the manufacture of thin film batteries, e.g. lithium batteries, the display industry and the photovoltaic (PV) industry, roll-to-roll deposition systems are of high interest. For example, the increasing demand for flexible touch panel elements, flexible displays, and flexible PV modules results in an increasing demand for depositing suitable layers in R2R-coaters.

With respect to the state of the art, reference is made to documents CN 107 841 723 A, US 4 389 970 A, and WO 2018/001523 A1.

Document CN 107 841 723 A describes a direct current sputtering device for non-gel double flexible copper clad laminate machining. The direct current sputtering device comprises a device box, an air inlet pipe is arranged on the upper surface of the device box, an air suction pipe is arranged on the lower surface of the device box, and electric air cylinders are arranged on the upper surface and the lower surface of the device box. The direct current sputtering device for non-gel double flexible copper clad laminate machining has the beneficial effects that the a base material which is subjected to direct current sputtering penetrates through the position between ceramic heating lamps on the upper layer and the lower layer, baking is conducted on the surface of the base material through heating of the ceramic heating lamps, then a metal layer can be completely adsorbed to the surface of the base material, thus the metal layer cannot be scraped by sealing plugs, the metal layer also cannot be damaged by a conveying roller in the follow-up conveying process through the conveying roller, the problem that a conveying roller in a traditional direct current sputtering device for non-gel double flexible copper clad laminate machining is prone to scraping a metal layer formed by direct current sputtering is effectively solved, and the practicability is good.

Document US 4 389 970 A describes an apparatus for raising a continuous substrate to a predetermined deposition temperature and thereafter maintaining it at that temperature as it advances through a glow discharge chamber. A lamp holder having a plurality of heater lamps extends substantially the length of the chamber. The lamps are selectively spaced apart along the length of travel of said substrate to provide a desired heating profile. A detector is engaged to control circuitry for continuously adjusting the intensity of the lamps to regulate substrate temperature.

Document WO 2018/001523 A1 describes deposition apparatus for coating a flexible substrate with a stack of layers. The deposition apparatus includes: a first spool chamber configured for housing a storage spool for providing the flexible substrate; a first deposition chamber arranged downstream from the first spool chamber and comprising a first coating drum configured for guiding the flexible substrate past a first plurality of deposition units; a second deposition chamber arranged downstream from the first deposition chamber and comprising a second coating drum configured for guiding the flexible substrate past a second plurality of deposition units; a second spool chamber arranged downstream from the second deposition chamber and configured for housing a wind-up spool for winding the flexible substrate thereon after deposition; and a roller assembly configured to transport the flexible substrate along a partially convex and partially concave substrate transportation path from the first spool chamber to the second spool chamber. Further, a method of coating a flexible substrate, particularly with the described deposition apparatus, is described.

There is a continuous demand for improved processing systems with which thin, uniform and high quality layers or layer stacks can be coated on flexible substrates. Improvements to the layers or layer stack systems being, for instance, having improved uniformity, improved product lifetime, and a lower number of defects per surface area. Accordingly, there is a demand for providing improved quality inspection methods as well as improved processing systems with processing quality inspection systems, e.g. for measuring coating thickness, which are capable of providing highly accurate measurement results.

### SUMMARY

In light of the above, a processing system for processing a flexible substrate, and a method of measuring at least one of a property of a flexible substrate and a property of one or more coatings on the flexible substrate according to the independent claims are provided. Further aspects, advantages, and features are apparent from the dependent claims, the description, and the accompanying drawings.

According to an aspect of the present disclosure, a processing system for processing a flexible substrate is provided. The processing system includes a vacuum chamber having a wall with an opening for the flexible substrate. Additionally, the processing system includes a substrate support for supporting the flexible substrate during transportation of the flexible substrate through the opening. The substrate support is a roller configured for guiding the flexible substrate during substrate transportation. The substrate support is attached to the wall. Further, the processing system includes a measurement assembly including a measurement device holder holding two or more measurement devices. The measurement device holder is attached to the wall. The two or more measurement devices are configured for measuring at least one of a thickness of the flexible substrate, a layer thickness of one or more coatings and a layer uniformity of the one or more coatings on the flexible substrate.

According to a further aspect of the present disclosure, the processing system is configured as a multiple drum roll-to-roll processing system for coating a flexible substrate on both sides is provided. The processing system further includes a first vacuum deposition chamber having a first coating drum configured for guiding the flexible substrate past one or more first deposition units. Additionally, the processing system includes a second vacuum deposition chamber having a second coating drum configured for guiding the flexible substrate past one or more second deposition units. Further, the processing system includes a transportation system configured for transporting the flexible substrate such that a front side of the flexible substrate faces the one or more first deposition units and a backside of the flexible substrate faces the one or more second deposition units. Moreover, the processing system includes first thickness measurement assembly, a second thickness measurement assembly, and a third thickness measurement assembly. The first thickness measurement assembly is attached to a wall of the first vacuum deposition chamber having a first opening for the flexible substrate. The second thickness measurement assembly is attached to a wall of the first vacuum deposition chamber having a second opening for the flexible substrate. The third thickness measurement assembly is attached to a wall of the second vacuum deposition chamber having an third opening for the flexible substrate.

According to another aspect of the present disclosure, a method of measuring at least one of a property of a flexible substrate and a property of one or more coatings on the flexible substrate is provided. The method includes supporting the flexible substrate by a substrate support during transportation of the flexible substrate through an opening provided in a wall of a vacuum chamber. the substrate support is a roller configured for guiding the flexible substrate during substrate transportation: The substrate support is attached to the wall. Further, the method includes measuring at least one of a thickness of the flexible substrate, a layer thickness of one or more coatings and a layer uniformity of the one or more coatings on the flexible substrate by using a measurement assembly. The measurement assembly includes a measurement device holder holding two or more measurement devices. The measurement device holder is attached to the wall. The two or more measurement devices are configured for measuring at least one of the thickness of the flexible substrate, the layer thickness of the one or more coatings and the layer uniformity of the one or more coatings on the flexible substrate.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods for operating the described apparatus include method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- FIG. 1: shows a schematic view of a processing system according to embodiments described herein;
- FIG. 2: shows a schematic view of a measurement assembly of a processing system according to embodiments described herein;
- FIG. 3: shows a schematic front view of a measurement assembly of a processing system according to further embodiments described herein;
- FIG.4: shows a schematic view of a processing system having a coating drum and one or more deposition units according to further embodiments described herein;
- FIG. 5: shows a schematic view of a multiple drum roll-to-roll processing system for coating a flexible substrate on both sides according to embodiments described herein; and
- FIG. 6: shows a block diagram for illustrating a method of measuring at least one of a property of a flexible substrate and a property of one or more coatings on the flexible substrate according to embodiments described.

### DETAILED DESCRIPTION OF EMBODIMENTS

Reference will now be made in detail to the various embodiments of the disclosure, one or more examples of which are illustrated in the figures. Within the following description of the drawings, same reference numbers refer to same components. Only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

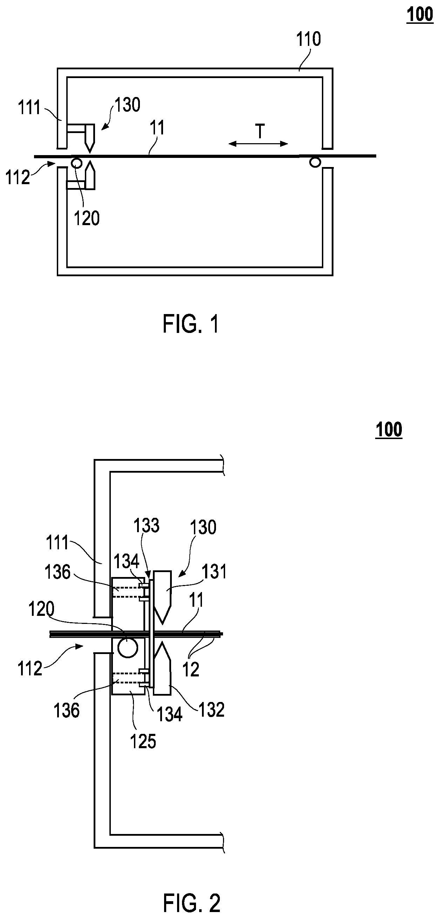

With exemplary reference to FIG. 1, a processing system 100 for processing a flexible substrate 11 according to the present disclosure is described.

According to embodiments, which can be combined with any other embodiments describe herein, the processing system 100 includes a vacuum chamber 110 having a wall 111 with an opening 112 for the flexible substrate 11. Additionally, as exemplarily shown in FIG. 1, the processing system 100 includes a substrate support 120 for supporting the flexible substrate 11 during transportation of the flexible substrate 11 through the opening 112. Further, the processing system 100 includes a measurement assembly 130 for measuring a property of the flexible substrate 11 and/or a property of one or more coatings on the flexible substrate 11. Fig. 2 shows the substrate with coatings 12 on the flexible substrate 11, particularly a first coating on the front side of the flexible substrate and a second coating on the backside of the flexible substrate. As exemplarily shown in FIG. 1, the measurement assembly 130 and the substrate support 120 are attached to the wall 111.

Accordingly, compared to the state of the art, the processing system as described herein beneficially provides for improved quality inspection of unprocessed and processed flexible substrates. In particular, by providing a measurement assembly and a substrate support both attached to the wall of the vacuum chamber negative influences on the measurement results can be reduced or even avoided. In particular, negative influences due to substrate tension, vacuum and/or thermal effects can be reduced or even eliminated. In other words, embodiments as described herein are beneficially configured such that the relative position of the measure assembly with respect to the unprocessed or processed substrate to be measured is substantially constant, i.e. the distance between the measure assembly and the unprocessed or processed substrate to be measured is not or only negligibly affected by vacuum deformation of the vacuum chamber and/or thermal deformation effects.

Before various further embodiments of the present disclosure are described in more detail, some aspects with respect to some terms used herein are explained.

In the present disclosure, a "processing system for processing a flexible substrate" can be understood as a system configured for continuously processing a flexible substrate. In particular, the processing system is a roll-to-toll processing system configured for depositing material on the flexible substrate. More specifically, the processing system can be a vacuum processing system having at least one vacuum chamber, particularly a vacuum deposition chamber. For instance, the processing system may be configured for a substrate length of 500 m or more, 1000 m or more, or several kilometers. The substrate width can be 300 mm or more, particularly 500 mm or more, more particularly 1 m or more. Further, the substrate width can be 3 m or less, particularly 2 m or less.

In the present disclosure, a "flexible substrate" can be understood as a bendable substrate. The term "flexible substrate" or "substrate" may be synonymously used with the term "foil" or the term "web". In particular, it is to be understood that embodiments of the processing system described herein can be utilized for processing any kind of flexible substrate, e.g. for manufacturing flat coatings with a uniform thickness. For example, a flexible substrate as described herein may include materials like PET, HC-PET, PE, PI, PU, TaC, OPP, CPP, one or more metals (e.g. copper or aluminium), paper, combinations thereof, and already coated substrates like Hard Coated PET (e.g. HC-PET, HC-TaC) or metal coated polymeric substrates (e.g. copper coated PET) and the like. In particular, the substrate may be a metal foil, e.g. a foil consisting of copper. For example, the substrate thickness can be 2 µm or more and 1 mm or less. Typically, the substrate is a non-transparent substrate.

In the present disclosure, a "vacuum chamber" can be understood as chamber configured to provide a vacuum within the chamber. Typically, the flexible substrate is transported through a vacuum chamber as described herein. The term "vacuum", as used herein, can be understood in the sense of a technical vacuum having a vacuum pressure of less than, for example, 10 mbar. Typically, the pressure in a vacuum chamber as described herein may be between 10⁻⁵ mbar and about 10⁻⁸ mbar, more typically between 10⁻⁵ mbar and 10⁻⁷ mbar, and even more typically between about 10⁻⁶ mbar and about 10⁻⁷ mbar.

**In** the present disclosure, an "opening for the flexible substrate" can be understood as an opening having dimensions such that flexible substrate can be transported through the opening. Accordingly, the opening for the flexible substrate may have an opening width of at least the width of the flexible substrate. Further, the opening for the flexible substrate may have an opening height of at least the thickness of the flexible substrate. Typically, opening width is larger than the width of the flexible substrate and the opening height is larger than the thickness of the flexible substrate. As described herein, the opening for the flexible substrate is provided in a wall of a vacuum chamber. Depending on the transport direction of the flexible substrate, the opening for the flexible substrate may be referred to as entrance opening or exit opening.

In the present disclosure, a "substrate support for supporting the flexible substrate" can be a roller. A "roller" may be understood as a device which provides a surface with which the flexible substrate or part of the flexible substrate may come in contact during transport of the flexible substrate. Typically, the substrate support includes a circular shape for contacting the flexible substrate during substrate transportation. The cylindrical shape is formed about a straight longitudinal axis of the substrate support, e.g. the roller. Accordingly, typically, the substrate support is configured for guiding the substrate while the substrate is transported. In particular, the substrate support can be part of a sealing device configured for vacuum sealing the opening in the wall of the vacuum chamber though which the substrate is transported into and out of the vacuum chamber.

In the present disclosure, a "measurement assembly for measuring at least one of a property of the flexible substrate and a property of one or more coatings on the flexible substrate" can be understood as an assembly configured for measuring one or more properties of the flexible substrate and/or one or more layers or coatings provided on the flexible substrate. For instance, the measurements assembly can be configured to measure at least one of a substrate thickness, a layer thickness, and a layer thickness uniformity. Typically, the measurement assembly includes one or more measurement devices, particularly optical measurement devices. In particular, the one or more measurement devices can be configured for measuring thickness via at least one of optical reflection, transmission, and optical interference. For example, the one or more measurement devices may be interferometers, particularly laser interferometers.

FIG. 2 shows a schematic exemplary embodiment of a measurement assembly of a processing system according to embodiments described herein. According to embodiments, which can be combined with any other embodiments describe herein, the substrate support 120 is part of a sealing device 125 for sealing the opening 112. In particular, the sealing device 125 is a gap sluice. As exemplary shown in FIG. 2, typically the sealing device 125 is disposed at or in the opening 112 for the flexible substrate 11. In particular, the sealing device 125 is tightly fixed to the wall 111, e.g. by screws or bolts. The sealing device may also be referred to as load lock or load lock valve.

As described herein, the substrate support 120 is a roller configured for guiding the substrate during substrate transportation. For instance, the substrate support 120 may include a rigid cylindrical tube or rigid cylindrical bar disposed within an elastic tube. The elastic tube can be inflatable such that a portion of the elastic tube can be pressed against the flexible substrate to provide a vacuum sealing during substrate transportation. It is to be understood, that other sealing devices of different configuration may be implemented. Further, it is to be understood that any sealing device configured for vacuum sealing an opening through which a flexible substrate is transported has a substrate support 120, i.e. a part of the sealing device being in contact with the flexible substrate when the opening is sealed. Moreover, it is to be understood that a sealing device as described herein is configured for providing a vacuum sealing during substrate transportation.

With exemplary reference to FIG. 2, the measurement assembly 130 includes a measurement device holder 133 holding two or more measurement devices. The measurement device holder 133 is attached to the wall 111 by fastening elements 136, e.g. screws or bolts. In particular, the measurement assembly 130 may be attached to the wall 111 via the sealing device 125. As exemplarily shown in FIG. 2, the fastening elements 136 may extend into the sealing device 125. Additionally or alternatively, the fastening elements 136 may extend through the sealing device 125 and be fixed to the wall 111.

According to embodiments, which can be combined with any other embodiments describe herein, one or more spacers 134 are provided for providing a gap between the sealing device 125 and the measurement device holder 133, as exemplarily shown in FIG. 2. Accordingly, the measurement device holder 133 can be arranged at a distance from the sealing device, which is beneficial for minimizing or avoiding influence of load lock forces on the measurement device holder 133. In other words, deformation of the measurement device holder 133 due to load lock forces can be reduced or even eliminated.

According to embodiments, which can be combined with any other embodiments describe herein, the measurement device holder 133 is made of a material having a coefficient of thermal expansion α of α ≤ 4 × 10⁻⁶ K⁻¹. In particular, the material of the measurement device holder 133 is a nickel-iron alloy, for example Invar. Providing the measurement device holder 133 made of a material as described herein is beneficial for reducing or even avoiding thermal deformation of the measurement device holder 133

According to embodiments, which can be combined with any other embodiments describe herein, the measurement assembly 130 includes a first measurement device 131 for measuring a front side 11A of the flexible substrate 11 and an opposite second measurement device 132 for measuring a backside 11B of the flexible substrate 11. Providing oppositely arranged measurement devices is beneficial for compensating winding related shifts of substrate position, such that the measurement quality and accuracy is improved. Typically, the first measurement device 131 and/or the second measurement device 132 are interferometers, particularly laser interferometers.

The measurement assembly is configured for measuring a coating thickness on the flexible substrate. In particular, the measurement assembly is configured for measuring a thickness of a top coating and a thickness of a back coating on the flexible substrate. In other words, measurement assembly is configured for measuring a double side coating on the flexible substrate.

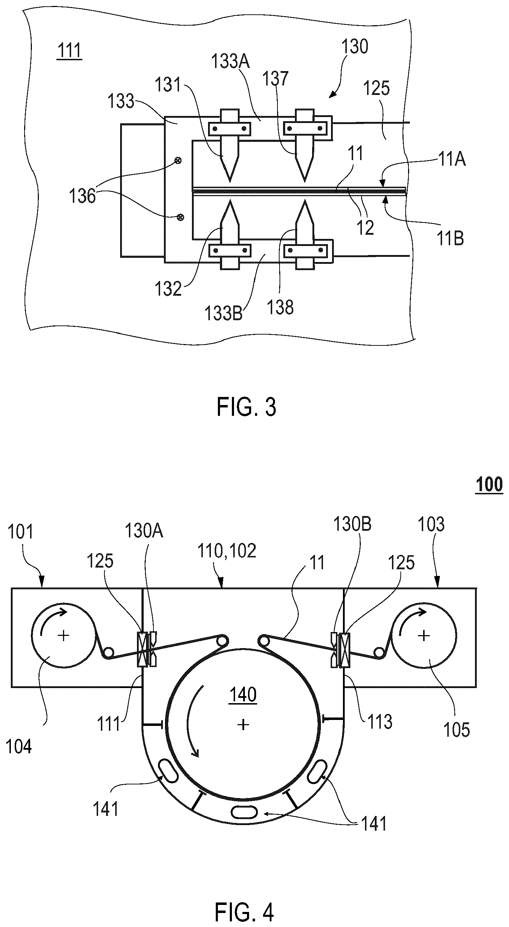

FIG. 3 shows a schematic front view of an exemplary measurement assembly of a processing system according to embodiments described herein. As exemplarily shown in FIG. 3, the measurement device holder 133 can have a C-shape configuration, e.g. having a first arm 133A and a second arm 133B. The first arm 133A and the second arm 133B are oppositely arranged. The first measurement device 131 may be mounted to the first arm 133A and the second measurement device 132 may be mounted to the second arm 133B. As exemplarily shown in FIG. 3, the measurement assembly 130 may further include a third measurement device 137 and a fourth measurement device 138. Typically, the third measurement device 137 is arranged and configured for measuring the front side 11A of the flexible substrate 11 and the fourth measurement device 138 is arranged and configured for measuring the backside 11B of the flexible substrate 11. The third measurement device 137 may be mounted to the first arm 133A, particularly next to the first measurement device 131. The fourth measurement device 138 may be mounted to the second arm 133B, particularly next to the second measurement device 132. Typically, the third measurement device 137 and/or the fourth measurement device 138 are interferometers, particularly laser interferometers.

Interferometers, particularly laser interferometers, have the advantage that very accurate thickness measurements can be carried out. In particular with interferometers, e.g. laser interferometers, distances can be measured with a resolution in the nanometer range. For example, the thickness of the substrate between two oppositely arranged measurement devices, particularly laser interferometers, can be determined by measuring the distance from top to the substrate and from bottom to the substrate. According to embodiments which can be combined with other embodiments described herein, first the uncoated substrate is measured, then the substrate with a first coating on a first side of the substrate, e.g. the a front side 11A, is measured, and after that the substrate with both sides coated, i.e. the first coating on the first side of the substrate and a second coating on a second side of the substrate, particularly the backside 11B, are measured. Accordingly, information about substrate thickness as well as about the thickness of the first coating and the second coating can be obtained.

With exemplary reference to FIG. 4, according to embodiments, which can be combined with any other embodiments describe herein, the processing system 100 is a roll-to-roll processing system having a coating drum 140 configured for guiding the flexible substrate 11 past one or more deposition units 141. According to embodiments, which can be combined with any other embodiments describe herein, at least one of the one or more deposition units 141 is configured for providing a lithium coating on the flexible substrate 11.

In the present disclosure, a "coating drum" can be understood as a drum or a roller having a substrate support surface for contacting the flexible substrate. In particular, the coating drum can be rotatable about a rotation axis and may include a substrate guiding region. Typically, the substrate guiding region is a curved substrate support surface, e.g. a cylindrically symmetric surface, of the coating drum. The curved substrate support surface of the coating drum may be adapted to be (at least partly) in contact with the flexible substrate during operation of the processing system.

In the present disclosure, a "deposition unit" can be understood as a unit or device configured for depositing material on a substrate. For example, the deposition unit may be a sputter deposition unit, a CVD deposition unit, an evaporation deposition unit, a PVD or PECVD deposition unit, or another suitable deposition unit.

As exemplarily shown in FIG. 4, according to embodiments, which can be combined with any other embodiments describe herein, the measurement assembly 130 includes a first measurement assembly 130A and a one or more further measurement assemblies 130B. Typically, the first measurement assembly 130A is arranged upstream from the coating drum 140. Accordingly, the first measurement assembly 130A can be used for measuring the unprocessed substrate. The one or more further measurement assemblies 130B are arranged downstream from the coating drum 140. Accordingly, the one or more further measurement assemblies 130B can be used for measuring the processed substrate, e.g. for measuring the thickness of one or more coatings provided on the front side 11A of the flexible substrate 11 and/or for measuring the thickness of one or more coatings provided on the backside 11B of the flexible substrate 11.

The terms "upstream from" and "downstream from" as used herein may refer to the position of the respective chamber or of the respective component with respect to another chamber or component along the substrate transportation path. For instance, as exemplarily shown in FIG. 4, during operation, the flexible substrate 11 is guided from the first spool chamber 101 through the processing chamber 102 and subsequently guided to the second spool chamber 103 along the substrate transportation path via a substrate transportation systems including a roller assembly. Accordingly, the processing chamber 102 is arranged downstream from the first spool chamber 101, and the first spool chamber 101 is arranged upstream from the processing chamber 102. When, during operation, the substrate is first guided by or transported past a first roller or a first component and subsequently guided by or transported past a second roller or a second component, the second roller or second component is arranged downstream from the first roller or first component.

According to embodiments, which can be combined with any other embodiments described herein, the one or more further measurement assemblies 130B are attached to a further wall 113 opposite the wall 111, as exemplarily shown in FIG. 4. The further wall 113 has a further opening for the flexible substrate 11. As exemplarily shown in FIG. 4, typically a further substrate support for supporting the flexible substrate 11 during transportation of the flexible substrate 11 through the further opening is attached to the further wall 113. As exemplarily shown in FIG. 4, typically the wall 111 is a wall provided between the first spool chamber 101 and the processing chamber 102. The further wall 113 can be a wall between the processing chamber 102 and the second spool chamber 103. As exemplarily shown in FIG. 4, the first spool chamber 101 typically houses a storage spool 104 for providing the flexible substrate 10. The second spool chamber 103 typically houses a wind-up spool 105 for winding the flexible substrate 10 thereon after processing.

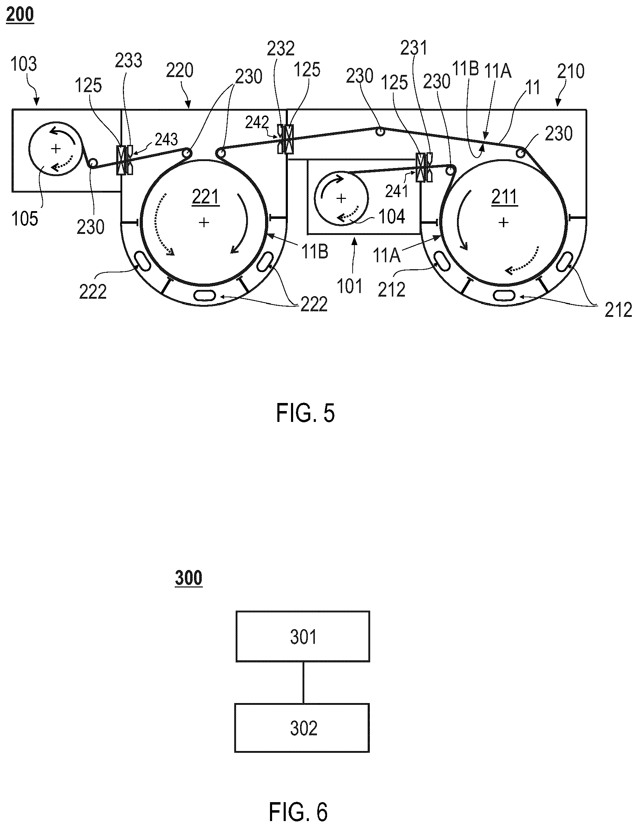

With exemplarily reference to FIG. 5, a multiple drum roll-to-roll processing system 200 for coating a flexible substrate 11 on both sides according to the present disclosure is described. According to embodiments, which can be combined with any other embodiments describe herein, the processing system includes a first vacuum deposition chamber 210 having a first coating drum 211 configured for guiding the flexible substrate 11 past one or more first deposition units 212. Additionally, the processing system includes a second vacuum deposition chamber 220 having a second coating drum 221 configured for guiding the flexible substrate 11 past one or more second deposition units 222. Further, as exemplarily shown in FIG. 5, the processing system includes a transportation system 230 for transporting the flexible substrate 11 through the processing system. Typically, the transportation system 230 includes a roller assembly configured for guiding the flexible substrate. As exemplarily shown in FIG. 5, the transportation system 230 is configured for transporting the flexible substrate 11 such that a front side 11A of the flexible substrate faces the one or more first deposition units and a backside 11B of the flexible substrate faces the one or more second deposition units 222. Accordingly, a double sided coating can be provided on the flexible substrate. It is to be understood, that according to embodiments, which can be combined with any other embodiments describe herein, the flexible substrate can be moved back and forth. In other words, in a first run the flexible substrate can be moved in a first direction, e.g. as exemplarily indicated by the arrows in FIG. 5. In a second run the flexible substrate can be moved in a second direction opposite the first direction. The second direction is indicated by the dotted arrows in FIG. 5.

Moreover, as exemplarily shown in FIG. 5, the processing system includes a first thickness measurement assembly 231, a second thickness measurement assembly 232, and a third thickness measurement assembly 233. The first thickness measurement assembly 231 is attached to a wall of the first vacuum deposition chamber having a first opening 241 for the flexible substrate. The second thickness measurement assembly 23 is attached to a wall of the second vacuum deposition chamber 220 having a second opening 242 for the flexible substrate. The third thickness measurement assembly 233 is attached to a wall of the second vacuum deposition chamber having an third opening 243 for the flexible substrate. For instance, the first opening 241 can be an entrance opening for the flexible substrate into the first vacuum deposition chamber 210. The second opening 242 can be an entrance opening for the flexible substrate into the second vacuum deposition chamber 220. The third opening 243 can be an exit opening for the flexible substrate out of the second processing chamber, e.g. into the second spool chamber 103 including the wind-up spool 105. The first thickness measurement assembly 231 and/or the second thickness measurement assembly 232 and/or the third thickness measurement assembly 233 can be configured according to the measurement assembly 130 as exemplarily described with reference to FIGS. 1 to 4.

With exemplarily reference to the block diagram of FIG. 6, a method 300 of measuring at least one of a property of a flexible substrate 11 and a property of one or more coatings 12 on the flexible substrate according to the present disclosure is described. According to embodiments, which can be combined with any other embodiments describe herein, the method 300 includes supporting (represented by block 301 in FIG. 6) the flexible substrate 11 by a substrate support 120) during transportation of the flexible substrate 11 through an opening 112 provided in a wall 111 of a vacuum chamber 110. The substrate support 120 is attached to the wall 111. Further, the method includes measuring (represented by block 302 in FIG. 6) at least one of a property of the flexible substrate 11 and a property of one or more coatings 12 on the flexible substrate 11 by using a measurement assembly 130 attached to the wall 111.

Accordingly, compared to the state of the art, an improved quality inspection method for unprocessed and processed flexible substrates. In particular, by using a measurement assembly and a substrate support both attached to the wall of the vacuum chamber negative influences on the measurement results can be reduced or even avoided. In particular, negative influences due to substrate tension, vacuum and/or thermal effects can be reduced or even eliminated.

According to embodiments, which can be combined with any other embodiments describe herein, at least one of the one or more coatings measured by the method as described herein is a lithium coating. Further, typically the at least one of the property measured by the measurement assembly employed in the method is a thickness.

According to embodiments, which can be combined with any other embodiments describe herein, the flexible substrate is selected form the group consisting of a polymeric substrate, particularly a PET substrate, a metallic substrate, particularly a copper substrate, and polymeric substrate with a metallic coating, particularly a PET substrate with a copper coating.

In view of the above, it is to be understood that compared to the state of the art, embodiments of the present disclosure beneficially provide processing systems and methods which are which are capable of providing highly accurate measurement results, particularly due to the fact that negative influences caused by substrate tension, vacuum and/or thermal effects are reduced or even eliminated.

While the foregoing is directed to embodiments, other and further embodiments may be devised without departing from scope of the invention, which is defined by the appended claims.

## Claims

1. A processing system (100) for processing a flexible substrate (11), comprising
- a vacuum chamber (110) having a wall (111) with an opening (112) for the flexible substrate (11);
- a substrate support (120) for supporting the flexible substrate (11) during transportation of the flexible substrate (11) through the opening (112), wherein the substrate support (120) is a roller configured for guiding the flexible substrate during substrate transportation, the substrate support (120) being attached to the wall (111); and
- a measurement assembly (130) comprising a measurement device holder (133) holding two or more measurement devices, the measurement device holder being attached to the wall (111), the two or more measurement devices being configured for measuring at least one of a thickness of the flexible substrate (11), a layer thickness of one or more coatings (12) and a layer thickness uniformity of the one or more coatings (12) on the flexible substrate (11) .

2. The processing system (100) of claim 1, further comprising one or more spacers (134) providing a gap between a sealing device (125) and the measurement device holder (133).

3. The processing system (100) of claim 1 or 2, the measurement device holder (133) being made of a material having a coefficient of thermal expansion α of α ≤ 4 × 10⁻⁶ K⁻¹, particularly the material being a nickel-iron alloy.

4. The processing system (100) of any of claims 1 to 3, the two or more measurement devices comprising a first measurement device (131) for measuring at least one of the thickness of the flexible substrate (11), the layer thickness and the layer uniformity of the one or more coatings (12) property of the flexible substrate (11) and the property of the one or more coatings at a front side of the flexible substrate (11), and an opposite second measurement device (132) for measuring at least one of the thickness of the flexible substrate (11), the layer thickness of the one or more coatings (12) and the layer uniformity of the one or more coatings (12) at a backside of the flexible substrate (11).

5. The processing system (100) of claim 4, wherein the first measurement device (131) and the second measurement device (132) are laser interferometers.

6. The processing system (100) of claim 2 or claim 2 in combination with any of claims 3 to 5, the measurement assembly (130) being attached to the wall (111) via the sealing device (125).

7. The processing system (100) of any of claims 1 to 6, the measurement assembly (130) being configured for a thickness of a top coating and a thickness of a back coating on the flexible substrate.

8. The processing system (100) of any of claims 1 to 7, the substrate processing system (100) being a roll-to-roll processing system having a coating drum (140) configured for guiding the flexible substrate (11) past one or more deposition units (141).

9. The processing system (100) of claim 8, wherein at least one of the one or more deposition units (141) are configured for providing a lithium coating on the flexible substrate.

10. The processing system (100) of claim 8 or 9, the measurement assembly (130) comprising a first measurement assembly (130A) being arranged upstream from the coating drum (140), and the substrate processing system further comprising one or more further measurement assemblies (130B) being arranged downstream from the coating drum (140).

11. The processing system (100) of claim 10, the one or more further measurement assemblies (135) being attached to a further wall (113) opposite the wall (111), the further wall (113) having a further opening (114) for the flexible substrate, and wherein a further substrate support (121) for supporting the flexible substrate (11) during transportation of the flexible substrate (11) through the further opening (114) is attached to the further wall (113).

12. The processing system (100) of any of claims 1 to 2 being configured as a multiple drum roll-to-roll processing system (200) for coating a flexible substrate (11) on both sides, further comprising
- a first vacuum deposition chamber (210) having a first coating drum (211) configured for guiding the flexible substrate past one or more first deposition units (212),
- a second vacuum deposition chamber (220) having a second coating drum (221) configured for guiding the flexible substrate (11) past one or more second deposition units (222),
- a transportation system (230) configured for transporting the flexible substrate such that a front side (11A) of the flexible substrate faces the one or more first deposition units and a backside (11B) of the flexible substrate faces the one or more second deposition units (222),
- a first thickness measurement assembly (231) attached to a wall of the first vacuum deposition chamber having a first opening (241) for the flexible substrate;
- a second thickness measurement assembly (232) attached to a wall of the second vacuum deposition chamber having an second opening (242) for the flexible substrate; and
- a third thickness measurement assembly (233) attached to a wall of the second vacuum deposition chamber having an third opening (243) for the flexible substrate.

13. A method (300) of measuring at least one of a property of a flexible substrate (11) and a property of one or more coatings (12) on the flexible substrate, the method comprising
- supporting the flexible substrate (11) by a substrate support (120) during transportation of the flexible substrate (11) through an opening (112) provided in a wall (111) of a vacuum chamber (110), wherein the substrate support (120) is a roller configured for guiding the flexible substrate during substrate transportation, the substrate support (120) being attached to the wall (111), and
- measuring at least one of a thickness of the flexible substrate (11), a layer thickness of one or more coatings (12) and a layer thickness uniformity of the one or more coatings (12) on the flexible substrate (11) by using a measurement assembly (130) comprising a measurement device holder (133) holding two or more measurement devices, the measurement device holder being attached to the wall (111), the two or more measurement devices being configured for measuring at least one of the thickness of the flexible substrate (11), the layer thickness of the one or more coatings (12) and the layer thickness uniformity of the one or more coatings (12) on the flexible substrate (11).

14. The method of claim 13, wherein at least one of the one or more coatings is a lithium coating.

15. The method of claim 13 or 14, wherein the flexible substrate is selected form the group consisting of a polymeric substrate, particularly a PET substrate, a metallic substrate, particularly a copper substrate, and polymeric substrate with a metallic coating, particularly a PET substrate with a copper coating.

## Patentansprüche

1. Bearbeitungssystem (100) zum Bearbeiten eines flexiblen Substrats (11), umfassend
- eine Vakuumkammer (110) mit einer Wand (111) mit einer Öffnung (112) für das flexible Substrat (11);
- einen Substratträger (120) zum Tragen des flexiblen Substrats (11) während des Transports des flexiblen Substrats (11) durch die Öffnung (112), wobei der Substratträger (120) eine Rolle ist, die zum Führen des flexiblen Substrats während des Substrattransports konfiguriert ist, wobei der Substratträger (120) an der Wand (111) befestigt ist; und
- eine Messanordnung (130) umfassend einen Messgerätehalter (133), der zwei oder mehr Messgeräte hält, wobei der Messgerätehalter an der Wand (111) befestigt ist, wobei die zwei oder mehr Messgeräte zum Messen von mindestens einem von einer Dicke des flexiblen Substrats (11), einer Schichtdicke von einer oder mehreren Beschichtungen (12) und einer Schichtdickengleichmäßigkeit der einen oder mehreren Beschichtungen (12) auf dem flexiblen Substrat (11) konfiguriert sind.

2. Bearbeitungssystem (100) nach Anspruch 1, ferner umfassend einen oder mehrere Abstandshalter (134), die einen Spalt zwischen einer Dichtungsvorrichtung (125) und dem Messgerätehalter (133) bereitstellen.

3. Bearbeitungssystem (100) nach Anspruch 1 oder 2, wobei der Messgerätehalter (133) aus einem Material mit einem Wärmeausdehnungskoeffizienten α von α ≤ 4 × 10⁻⁶ K⁻¹ hergestellt ist, wobei das Material insbesondere eine Nickel-EisenLegierung ist.

4. Bearbeitungssystem (100) nach einem der Ansprüche 1 bis 3, wobei die zwei oder mehr Messgeräte ein erstes Messgerät (131) zum Messen von mindestens einem von der Dicke des flexiblen Substrats (11), der Schichtdicke und der Schichtgleichmäßigkeit der einen oder mehreren Beschichtungen (12) als Eigenschaft des flexiblen Substrats (11) und der Eigenschaft der einen oder mehreren Beschichtungen an einer Vorderseite des flexiblen Substrats (11) und ein gegenüberliegendes zweites Messgerät (132) zum Messen von mindestens einem von der Dicke des flexiblen Substrats (11), der Schichtdicke der einen oder mehreren Beschichtungen (12) und der Schichtgleichmäßigkeit der einen oder mehreren Beschichtungen (12) an einer Rückseite des flexiblen Substrats (11) umfassen.

5. Bearbeitungssystem (100) nach Anspruch 4, wobei das erste Messgerät (131) und das zweite Messgerät (132) Laserinterferometer sind.

6. Bearbeitungssystem (100) nach Anspruch 2 oder Anspruch 2 in Kombination mit einem der Ansprüche 3 bis 5, wobei die Messanordnung (130) über die Dichtungsvorrichtung (125) an der Wand (111) befestigt ist.

7. Bearbeitungssystem (100) nach einem der Ansprüche 1 bis 6, wobei die Messanordnung (130) für eine Dicke einer oberen Beschichtung und eine Dicke einer hinteren Beschichtung auf dem flexiblen Substrat konfiguriert ist.

8. Bearbeitungssystem (100) nach einem der Ansprüche 1 bis 7, wobei das Substratbearbeitungssystem (100) ein Rolle-zu-Rolle-Bearbeitungssystem mit einer Beschichtungstrommel (140) ist, die zum Führen des flexiblen Substrats (11) vorbei an einer oder mehreren Abscheidungseinheiten (141) konfiguriert ist.

9. Bearbeitungssystem (100) nach Anspruch 8, wobei mindestens eine der einen oder mehreren Abscheidungseinheiten (141) zum Bereitstellen einer Lithiumbeschichtung auf dem flexiblen Substrat konfiguriert ist.

10. Bearbeitungssystem (100) nach Anspruch 8 oder 9, wobei die Messanordnung (130) eine erste Messanordnung (130A) umfasst, die stromaufwärts von der Beschichtungstrommel (140) angeordnet ist, und das Substratbearbeitungssystem ferner eine oder mehrere weitere Messanordnungen (130B) umfasst, die stromabwärts von der Beschichtungstrommel (140) angeordnet sind.

11. Bearbeitungssystem (100) nach Anspruch 10, wobei die eine oder mehreren weiteren Messanordnungen (135) an einer weiteren Wand (113) gegenüber der Wand (111) befestigt sind, wobei die weitere Wand (113) eine weitere Öffnung (114) für das flexible Substrat aufweist, und wobei ein weiterer Substratträger (121) zum Tragen des flexiblen Substrats (11) während des Transports des flexiblen Substrats (11) durch die weitere Öffnung (114) an der weiteren Wand (113) befestigt ist.

12. Bearbeitungssystem (100) nach einem der Ansprüche 1 bis 2, das als ein Mehrfachtrommel-Rolle-zu-Rolle-Bearbeitungssystem (200) zum beidseitigen Beschichten eines flexiblen Substrats (11) konfiguriert ist, ferner umfassend
- eine erste Vakuumabscheidungskammer (210) mit einer ersten Beschichtungstrommel (211), die zum Führen des flexiblen Substrats vorbei an einer oder mehreren ersten Abscheidungseinheiten (212) konfiguriert ist,
- eine zweite Vakuumabscheidungskammer (220) mit einer zweiten Beschichtungstrommel (221), die zum Führen des flexiblen Substrats (11) vorbei an einer oder mehreren zweiten Abscheidungseinheiten (222) konfiguriert ist,
- Transportsystem (230), das zum Transportieren des flexiblen Substrats konfiguriert ist, so dass eine Vorderseite (11A) des flexiblen Substrats der einen oder den mehreren ersten Abscheidungseinheiten zugewandt ist und eine Rückseite (11B) des flexiblen Substrats der einen oder den mehreren zweiten Abscheidungseinheiten (222) zugewandt ist,
- eine erste Dickenmessanordnung (231), die an einer Wand der ersten Vakuumabscheidungskammer mit einer ersten Öffnung (241) für das flexible Substrat befestigt ist;
- eine zweite Dickenmessanordnung (232), die an einer Wand der zweiten Vakuumabscheidungskammer mit einer zweiten Öffnung (242) für das flexible Substrat befestigt ist; und
- dritte Dickenmessanordnung (233), die an einer Wand der zweiten Vakuumabscheidungskammer mit einer dritten Öffnung (243) für das flexible Substrat befestigt ist.

13. Verfahren (300) zum Messen von mindestens einem von einer Eigenschaft eines flexiblen Substrats (11) und einer Eigenschaft von einer oder mehreren Beschichtungen (12) auf dem flexiblen Substrat, wobei das Verfahren umfasst
- Tragen des flexiblen Substrats (11) durch einen Substratträger (120) während des Transports des flexiblen Substrats (11) durch eine Öffnung (112), die in einer Wand (111) einer Vakuumkammer (110) bereitgestellt ist, wobei der Substratträger (120) eine Rolle ist, die zum Führen des flexiblen Substrats während des Substrattransports konfiguriert ist, wobei der Substratträger (120) an der Wand (111) befestigt ist, und
- Messen von mindestens einem von einer Dicke des flexiblen Substrats (11), einer Schichtdicke von einer oder mehreren Beschichtungen (12) und einer Schichtdickengleichmäßigkeit der einen oder mehreren Beschichtungen (12) auf dem flexiblen Substrat (11) unter Verwendung einer Messanordnung (130) umfassend einen Messgerätehalter (133), der zwei oder mehr Messgeräte hält, wobei der Messgerätehalter an der Wand (111) befestigt ist, wobei die zwei oder mehr Messgeräte zum Messen von mindestens einem von der Dicke des flexiblen Substrats (11), der Schichtdicke der einen oder mehreren Beschichtungen (12) und der Schichtdickengleichmäßigkeit der einen oder mehreren Beschichtungen (12) auf dem flexiblen Substrat (11) konfiguriert sind.

14. Verfahren nach Anspruch 13, wobei mindestens eine der einen oder mehreren Beschichtungen eine Lithiumbeschichtung ist.

15. Verfahren nach Anspruch 13 oder 14, wobei das flexible Substrat ausgewählt ist aus der Gruppe bestehend aus einem Polymersubstrat, insbesondere einem PET-Substrat, einem metallischen Substrat, insbesondere einem Kupfersubstrat, und einem Polymersubstrat mit einer metallischen Beschichtung, insbesondere einem PET-Substrat mit einer Kupferbeschichtung.

## Revendications

1. Système de traitement (100) pour traiter un substrat souple (11), comprenant :
- une chambre à vide (110) ayant une paroi (111) avec une ouverture (112) pour le substrat souple (11) ;
- un support de substrat (120) pour supporter le substrat souple (11) pendant le transport du substrat souple (11) à travers l'ouverture (112), dans lequel le support de substrat (120) est un rouleau configuré pour guider le substrat souple pendant le transport de substrat, le support de substrat (120) étant fixé à la paroi (111) ; et
- un ensemble de mesure (130) comprenant un support de dispositif de mesure (133) maintenant deux dispositifs de mesure ou plus, le support de dispositif de mesure étant fixé à la paroi (111), les deux dispositifs de mesure ou plus étant configurés pour mesurer au moins l'une d'une épaisseur du substrat souple (11), d'une épaisseur de couche d'un ou plusieurs revêtements (12) et d'une uniformité d'épaisseur de couche des un ou plusieurs revêtements (12) sur le substrat souple (11).

2. Système de traitement (100) selon la revendication 1, comprenant en outre une ou plusieurs entretoises (134) fournissant un espace entre un dispositif d'étanchéité (125) et le support de dispositif de mesure (133).

3. Système de traitement (100) selon la revendication 1 ou 2, le support de dispositif de mesure (133) étant constitué d'un matériau ayant un coefficient de dilatation thermique α de α ≤ 4 × 10⁻⁶*K*⁻¹, le matériau étant en particulier un alliage nickel-fer.

4. Système de traitement (100) selon l'une quelconque des revendications 1 à 3, les deux dispositifs de mesure ou plus comprenant un premier dispositif de mesure (131) pour mesurer au moins l'une de l'épaisseur du substrat souple (11), de la propriété d'épaisseur de couche et d'uniformité de couche des un ou plusieurs revêtements (12) du substrat souple (11) et de la propriété des un ou plusieurs revêtements au niveau d'un côté avant du substrat souple (11), et un second dispositif de mesure (132) opposé pour mesurer au moins l'une de l'épaisseur du substrat souple (11), de l'épaisseur de couche des un ou plusieurs revêtements (12) et de l'uniformité de couche des un ou plusieurs revêtements (12) au niveau d'un côté arrière du substrat souple (11).

5. Système de traitement (100) selon la revendication 4, dans lequel le premier dispositif de mesure (131) et le second dispositif de mesure (132) sont des interféromètres laser.

6. Système de traitement (100) selon la revendication 2 ou la revendication 2 en combinaison avec l'une quelconque des revendications 3 à 5, l'ensemble de mesure (130) étant fixé à la paroi (111) par l'intermédiaire du dispositif d'étanchéité (125).

7. Système de traitement (100) selon l'une quelconque des revendications 1 à 6, l'ensemble de mesure (130) étant configuré pour une épaisseur d'un revêtement supérieur et une épaisseur d'un revêtement arrière sur le substrat souple.

8. Système de traitement (100) selon l'une quelconque des revendications 1 à 7, le système de traitement de substrat (100) étant un système de traitement rouleau à rouleau ayant un tambour de revêtement (140) configuré pour guider le substrat souple (11) au-delà d'une ou plusieurs unités de dépôt (141).

9. Système de traitement (100) selon la revendication 8, dans lequel au moins l'une des une ou plusieurs unités de dépôt (141) est configurée pour fournir un revêtement de lithium sur le substrat souple.

10. Système de traitement (100) selon la revendication 8 ou 9, l'ensemble de mesure (130) comprenant un premier ensemble de mesure (130A) agencé en amont du tambour de revêtement (140), et le système de traitement de substrat comprenant en outre un ou plusieurs ensembles de mesure supplémentaires (130B) agencés en aval du tambour de revêtement (140).

11. Système de traitement (100) selon la revendication 10, les un ou plusieurs ensembles de mesure supplémentaires (135) étant fixés à une paroi supplémentaire (113) opposée à la paroi (111), la paroi supplémentaire (113) ayant une ouverture supplémentaire (114) pour le substrat souple, et dans lequel un support de substrat supplémentaire (121) pour supporter le substrat souple (11) pendant le transport du substrat souple (11) à travers l'ouverture supplémentaire (114) est fixé à la paroi supplémentaire (113).

12. Système de traitement (100) selon l'une quelconque des revendications 1 à 2 configuré comme un système de traitement rouleau à rouleau à tambours multiples (200) pour revêtir un substrat souple (11) des deux côtés, comprenant en outre
- une première chambre de dépôt sous vide (210) ayant un premier tambour de revêtement (211) configuré pour guider le substrat souple au-delà d'une ou plusieurs premières unités de dépôt (212),
- une seconde chambre de dépôt sous vide (220) ayant un second tambour de revêtement (221) configuré pour guider le substrat souple (11) au-delà d'une ou plusieurs secondes unités de dépôt (222),
- un système de transport (230) configuré pour transporter le substrat souple de telle sorte qu'un côté avant (11A) du substrat souple fait face aux une ou plusieurs premières unités de dépôt et un côté arrière (11B) du substrat souple fait face aux une ou plusieurs secondes unités de dépôt (222),
- un premier ensemble de mesure d'épaisseur (231) fixé à une paroi de la première chambre de dépôt sous vide ayant une première ouverture (241) pour le substrat souple ;
- un deuxième ensemble de mesure d'épaisseur (232) fixé à une paroi de la seconde chambre de dépôt sous vide ayant une deuxième ouverture (242) pour le substrat souple ; et
- un troisième ensemble de mesure d'épaisseur (233) fixé à une paroi de la seconde chambre de dépôt sous vide ayant une troisième ouverture (243) pour le substrat souple.

13. Procédé (300) de mesure d'au moins une d'une propriété d'un substrat souple (11) et d'une propriété d'un ou plusieurs revêtements (12) sur le substrat souple, le procédé comprenant
- le support du substrat souple (11) par un support de substrat (120) pendant le transport du substrat souple (11) à travers une ouverture (112) prévue dans une paroi (111) d'une chambre à vide (110), dans lequel le support de substrat (120) est un rouleau configuré pour guider le substrat souple pendant le transport de substrat, le support de substrat (120) étant fixé à la paroi (111), et
- la mesure d'au moins l'une d'une épaisseur du substrat souple (11), d'une épaisseur de couche d'un ou plusieurs revêtements (12) et d'une uniformité d'épaisseur de couche des un ou plusieurs revêtements (12) sur le substrat souple (11) en utilisant un ensemble de mesure (130) comprenant un support de dispositif de mesure (133) maintenant deux dispositifs de mesure ou plus, le support de dispositif de mesure étant fixé à la paroi (111), les deux dispositifs de mesure ou plus étant configurés pour mesurer au moins l'une de l'épaisseur du substrat souple (11), de l'épaisseur de couche des un ou plusieurs revêtements (12) et de l'uniformité d'épaisseur de couche des un ou plusieurs revêtements (12) sur le substrat souple (11).

14. Procédé selon la revendication 13, dans lequel au moins l'un des un ou plusieurs revêtements est un revêtement de lithium.

15. Procédé selon la revendication 13 ou 14, dans lequel le substrat souple est sélectionné dans le groupe constitué d'un substrat polymère, en particulier d'un substrat en PET, d'un substrat métallique, en particulier d'un substrat en cuivre, et d'un substrat polymère avec un revêtement métallique, en particulier d'un substrat en PET avec un revêtement de cuivre.
